# EUROPEAN PATENT APPLICATION

(11) **EP 3 540 796 A1**
(43) Date of publication of application: **18.09.2019**
(21) Application number: 18162100.4
(22) Date of filing: 15.03.2018
(51) Int. Cl.: H01L 41/047, H01L 41/09, H01L 41/193, F03G 7/00

(54) **ACTUATOR DEVICE BASED ON AN ELECTROACTIVE MATERIAL**

(71) Applicant: Koninklijke Philips N.V., 5656 AE Eindhoven (NL)
(72) Inventor: JOHNSON, Mark Thomas, 5656 AE Eindhoven (NL); HOVENKAMP, Ronald Antonie, 5656 AE Eindhoven (NL); KRIEGE, Jan Cornelis, 5656 AE Eindhoven (NL); VAN DEN ENDE, Daan Anton, 5656 AE Eindhoven (NL); HENDRIKS, Cornelis Petrus, 5656 AE Eindhoven (NL)
(74) Representative: de Haan, Poul Erik

(57) **Abstract**

An electroactive material actuator is clamped along one edge and has a pre-bend about a first axis which is parallel to said edge and/or about a second axis which is perpendicular to said edge. The actuator expands with expansion coefficients along the first and second axes which differ by less than 20%. This combination of isotropic (or near isotropic) expansion with a pre-bend across at least one of main axes of the device (i.e. the axes which form the general plane of the actuator) gives rise to various additional operating characteristics.

## Description

### FIELD OF THE INVENTION

This invention relates to actuator devices which make use of electroactive materials, such as electroactive polymers.

### BACKGROUND OF THE INVENTION

Electroactive polymers (EAP) are an emerging class of materials within the field of electrically responsive materials. EAPs can work as sensors or actuators and can easily be manufactured into various shapes allowing easy integration into a large variety of systems.

Materials have been developed with characteristics such as actuation stress and strain which have improved significantly over the last ten years. Technology risks have been reduced to acceptable levels for product development so that EAPs are commercially and technically becoming of increasing interest. Advantages of EAPs include low power, small form factor, flexibility, noiseless operation, accuracy, the possibility of high resolution, fast response times, and cyclic actuation.

The improved performance and particular advantages of EAP material give rise to applicability to new applications.

An EAP device can be used in any application in which a small amount of movement of a component or feature is desired, based on electric actuation. Similarly, the technology can be used for sensing small movements.

The use of EAPs enables functions which were not possible before, or offers a big advantage over common sensor / actuator solutions, due to the combination of a relatively large deformation and force in a small volume or thin form factor, compared to common actuators. EAPs also give noiseless operation, accurate electronic control, fast response, and a large range of possible actuation frequencies, such as 0 - 20 kHz.

Devices using electroactive polymers can be subdivided into field-driven and ionic-driven materials.

Examples of field-driven EAPs are dielectric elastomers, electrostrictive polymers (such as PVDF based relaxor polymers or polyurethanes) and liquid crystal elastomers (LCE).

Examples of ionic-driven EAPs are conjugated polymers, carbon nanotube (CNT) polymer composites and Ionic Polymer Metal Composites (IPMC).

Field-driven EAPs are actuated by an electric field through direct electromechanical coupling, while the actuation mechanism for ionic EAPs involves the diffusion of ions. Both classes have multiple family members, each having their own advantages and disadvantages.

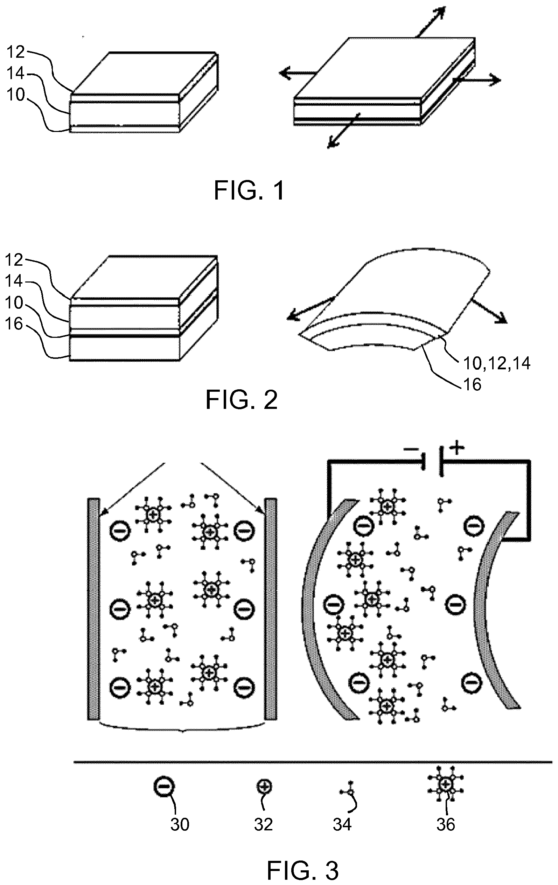

Figures 1 and 2 show two possible operating modes for an EAP device.

The device comprises an electroactive polymer layer 14 sandwiched between electrodes 10, 12 on opposite sides of the electroactive polymer layer 14.
Figure 1 shows a device which is not clamped. A voltage is used to cause the electroactive polymer layer to expand in all directions as shown.
Figure 2 shows a device which is designed so that the expansion arises only in one direction. The device is supported by a carrier layer 16. A voltage is used to cause the electroactive polymer layer to curve or bow.

The nature of this movement for example arises from the interaction between the active layer which expands when actuated, and the passive carrier layer. To obtain the asymmetric curving around an axis as shown, molecular orientation (film stretching) may for example be applied, forcing the movement in one direction.

The expansion in one direction may result from the asymmetry in the electroactive polymer, or it may result from asymmetry in the properties of the carrier layer, or a combination of both.

The electrodes in Figures 1 and 2 for example create an electric field for a field-driven device. Figure 3 shows an example of a current driven ionic device. The actuation mechanism involves the diffusion of ions and/or electrochemical oxidation and reduction. Figure 3 shows the structure of an Ionic Polymer Metal Composite (IPMC). There are fixed anions 30, movable cations 32 and water molecules 34 which attach to the cations to form hydrated cations. These move in response to an applied actuation signal.

EAP actuators are typically formed as bending actuators. They may for example be clamped at first edge, with the actuator projecting from that edge. The projecting part then bends in response to actuation, and the actuation part is for example the remote tip. A double-clamped arrangement is clamped at opposing edges and is caused to bow in response to actuation. The actuation part is then for example the middle of the structure.

These arrangements give little freedom to design particular modes of operation, for example it is difficult to tune the stiffness or the speed of operation in a simple way.

US 2002/0175594 discloses a bending actuator in which a pre-bend is formed about an axis perpendicular to the desired bending axis. The actuator is constrained to bend only about the desired bending axis. The result is that a kink forms during bending, and this provides a change in actuation response.

This provides one additional actuation response, but there remains a need for other actuation modes to be provided to improve the versatility of the actuator design.

### SUMMARY OF THE INVENTION

There is therefore a need for additional modes of operation of an electroactive material actuator.

It is an object of the current invention to fulfill the aforementioned need at least partially. This object is achieved at least partially by the device and method as defined by the independent claims. The dependent claims provide advantageous embodiments.

According to examples in accordance with an aspect of the invention, there is provided a device comprising:
- an electroactive material actuator unit comprising a plate shaped structure (10) and a first edge (12);
- a support (14) to which the first edge (12) of the electroactive material unit is clamped, the ends of the first edge defining end points of an imaginary straight edge line (18); and
wherein the actuator unit:
- has a pre-bend about a first axis (21) which is parallel to said imaginary edge line and/or about a second axis (22) which is perpendicular to said imaginary edge line, and
- is adapted to expand with expansion coefficients along the first and/or second axes which differ by less than 20%.

This device has an actuator unit clamped along one edge (referred to as the first edge) to a support. The actuator unit projects from that first edge. There is a pre-bend so that the actuator is not planar in its relaxed state. The pre-bend is either about an axis parallel to the first edge and/or perpendicular to the first edge (or, more precisely, parallel or perpendicular to an imaginary straight line drawn between the end points of the first edge, since the first edge may itself include the pre-bend). Thus, if the edge when clamped is not pre-bent, then the imaginary straight line overlaps with the real clamped edge line.

The pre-bend may be considered to form a curled shape. Along the first edge there may be one direction of bending, but there may also be multiple directions of bending.

The actuator expands isotropically in-plane when actuated, or near to isotropically. Thus, there is expansion across the pre-bend as well as along the axis of the pre-bend. The different effects of these two expansion directions, based on the interaction with the pre-bend, enable different bending modes to be designed, in particular with different stiffness behavior and different speed of response. The isotropic expansion acts to increase the radius of bending upon actuation and this then reduces stiffness to bending about an orthogonal direction. The actuator can have multiple mean curvatures (i.e. with different radius in different directions).

The actuator unit has a plate or sheet like shape. This does not mean that it is entirely flat, because it has a pre-bend in at least one direction when mounted (clamped) to the support. The unit may have a circumferential shape (outer shape) of a particular kind. It may for example be rectangular or square. The unit is plate-shaped in that it may be formed by deformation (without kinks) from a planar sheet. The deformation may be added when or through clamping the unit to the support. The plate can be seen as a pre-bent plate having an overall more or less planar appearance, for example with a thickness variation from perfectly planar which is in the relaxed state less than 40% of maximum lateral dimension (e.g. a diagonal), for example less than 25% and for example less than 10%. Thus, the plate when viewed form for example a top side may have a concave or convex shape.

The first edge may be straight where it connects to the support. If there is a pre-bend about an axis parallel to the edge, then the edge is in any case straight. However, even if there is a pre-bend about an axis perpendicular to the edge (so the edge would be curved), the edge may be straightened where it connects to the support. Thus, the actuator no longer has a constant cross sectional shape from the edge to the tip, but instead the pre-bend is non-uniform and progresses between the edge (where it is forced to be straightened) to the remote tip where the pre-bend is in place.

The first edge may instead be curved where it connects to the support. In particular, if there is a pre-bend about an axis perpendicular to the edge, the edge has a natural curvature and this is preserved at the connection to the support. In this case an imaginary line drawn between the outer ends of the first edge may be used as an orientational reference for axis such as bending axes.

The outer shape (circumferential shape) preferably is rectangular.

The rectangle may have any length to width ratio, for example between 0.1 and 100. However, in one set of examples, the rectangle has a length to width ratio of 2 or less. This has been found to be particularly suitable for creating a fast response speed, particularly when combined with pre-bends about both axes. The rectangle may even have a length to width ratio of 1 or less.

The or each pre-bend for example has a radius in the range 5mm to 50mm.

The actuator unit may have a pre-bend about only one axis or it may have a pre-bend about the first axis and about the second axis.

Typically, one pre-bend has a very different radius of curvature than the other. This arrangement may allow a snap-through behavior. The resistance to bending observes a step change when the curvature about one axis drops below a threshold (due to the isotropic expansion). The bending about the other axis then becomes much easier.

By way of example, a ratio of the radius of smaller radius (tighter) pre-bend to the radius of the larger radius (flatter) pre-bend may be in the range 0 to 0.5, such as 0 to 0.1.

The smaller radius pre-bend is for example across the width direction of the actuator.

This enables operation with a degree of bistability, which can have applications in the control of matrix array of actuators.

The electroactive material actuator unit may have a different stiffness when actuated in one direction compared to when actuated in an opposite direction. This can also be achieved by combining both pre-bends. The curvature about one axis, which resists the desired bending about the other axis, may be increased making the actuator stiffer when actuated in one direction (e.g. one polarity of drive signal), whereas the curvature about the one axis is decreased making the actuator less stiff when actuated in the other direction (e.g. an opposite polarity of drive signal).

The pre-bend about the first axis and/or about the second axis may have a radius of curvature which varies with position. Thus, a uniform bend is not essential.

The electroactive material actuator unit may be a current-driven actuator. These may be implemented as low voltage devices but they can suffer from slow response times. The use of the pre-bend with isotropic actuation enables improved response times to be achieved. The electroactive material actuator unit may be an ionic polymer metal composite actuator.

In an alternative arrangement, the electroactive material actuator unit is a field-driven actuator.

### BRIEF DESCRIPTION OF THE DRAWINGS

Examples of the invention will now be described in detail with reference to the accompanying drawings, in which:
Figure 1 shows a known electroactive polymer device which is not clamped;
Figure 2 shows a known electroactive polymer device which is constrained by a backing layer;
Figure 3 shows a current driven electroactive polymer device;

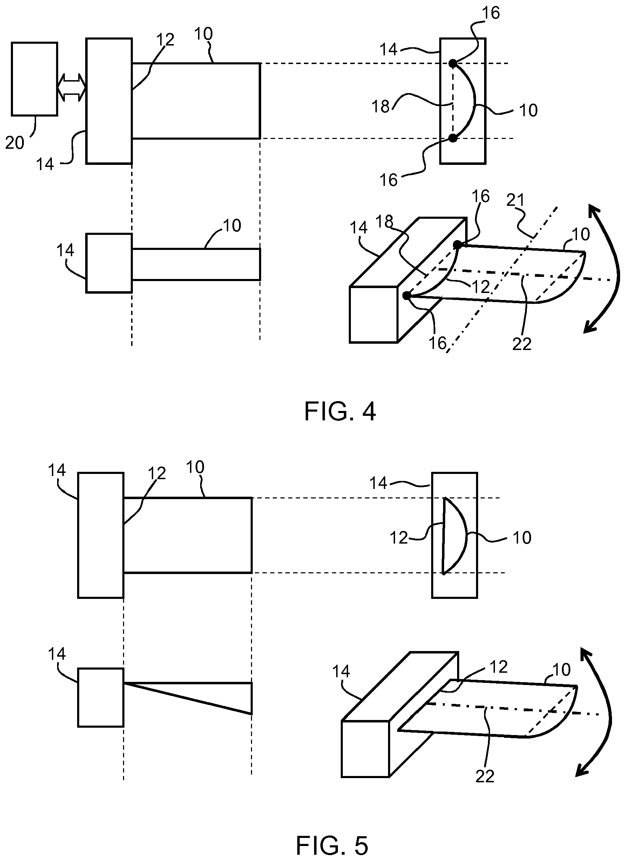

Figure 4 shows a first example of an electroactive material actuator device;
Figure 5 shows a second example of an electroactive material actuator device;

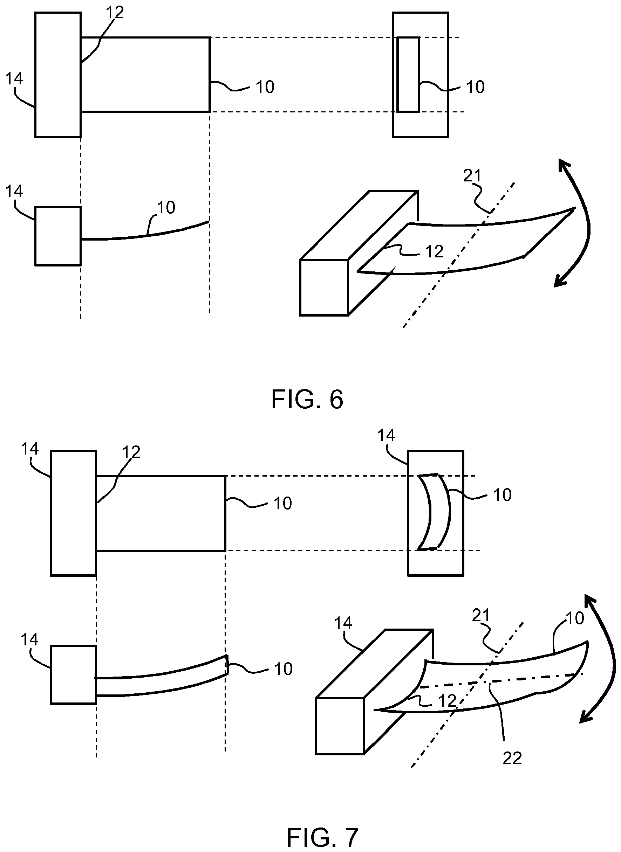

Figure 6 shows a third example of an electroactive material actuator device;
Figure 7 shows a fourth example of an electroactive material actuator device;

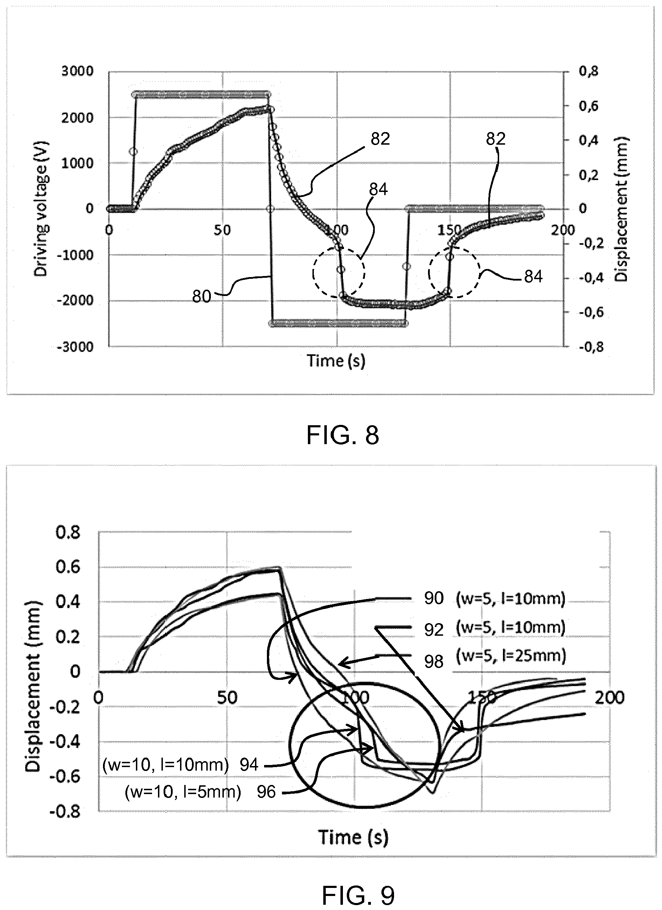

Figure 8 shows a driving scheme for driving the actuator around a snap-through working point;
Figure 9 shows that different aspect ratios change the snap-through effect shown in Figure 8;

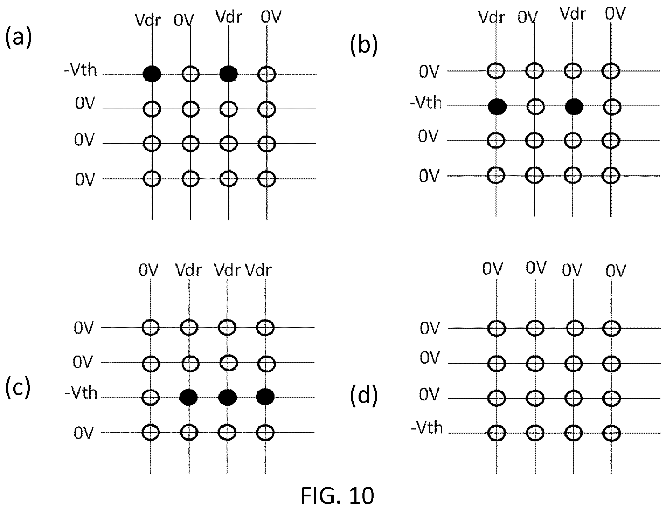

Figure 10 shows how a passive matrix driving scheme may be implemented; and

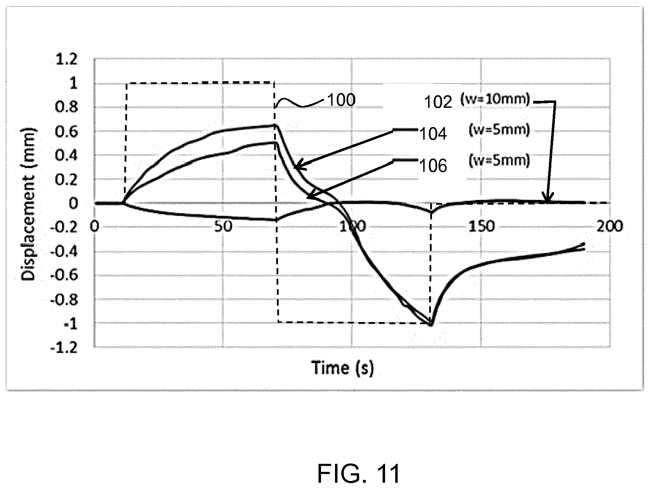

Figure 11 shows a plot of displacement versus time for the same actuation timings as in Figure 8 for a pre-bend perpendicular to the main examples of Figure 8.

### DETAILED DESCRIPTION OF THE EMBODIMENTS

The invention will be described with reference to the Figures.

It should be understood that the detailed description and specific examples, while indicating exemplary embodiments of the apparatus, systems and methods, are intended for purposes of illustration only and are not intended to limit the scope of the invention. These and other features, aspects, and advantages of the apparatus, systems and methods of the present invention will become better understood from the following description, appended claims, and accompanying drawings. It should be understood that the Figures are merely schematic and are not drawn to scale. It should also be understood that the same reference numerals are used throughout the Figures to indicate the same or similar parts.

The invention provides an electroactive material actuator which is clamped along first edge and which has a pre-bend about a first axis which is parallel to said edge and/or about a second axis which is perpendicular to said edge. The actuator expands with expansion coefficients along the first and second axes which differ by less than 20%. This combination of isotropic (or near isotropic) expansion with a pre-bend across at least one of main axes of the device (i.e. the axes which form the general plane of the actuator) gives rise to various additional operating characteristics.

Figure 4 shows three orthographic projections and a perspective view for a first example of the device. The device comprises an electroactive material actuator unit 10 comprising a plate shaped structure. The unit 10 has a rectangular shape in this example when viewed from above. The first edge 12 of the electroactive material unit is clamped to a support 14. Other shapes are possible.

The ends 16 of the first edge 12 define end points of an edge line 18.

A driver 20 is provided for applying an actuation signal to the electroactive material actuator unit. The driver is conventional, and for example provides a drive voltage or a drive current, depending on the type of actuator unit.

In general, the actuator unit 10 has a pre-bend about a first axis 21 which is parallel to said edge line 18 and/or about a second axis 22 which is perpendicular to said edge line 18. The example of Figure 4 has a pre-bend around the second axis 22. Note that the first and second axes lie in the general plane of the actuator unit.

In the example of Figure 4, the pre-bend is the same at all positions along the length of the unit. Thus, the edge 12 also has the pre-bend, and the actuator unit 10 is attached to the support 14 with this bent shape.

The actuator is adapted to expand approximately or fully isotropically, for example with expansion coefficients along the first and second axes which differ by less than 20%. This can be achieved by providing an electroactive polymer layer which is not treated to introduce anisotropic behavior.

The pre-bend means the actuator is not planar in its relaxed state. The pre-bend may be considered to form a curled shape. In the example of Figure 4, the actuator unit is curled across its width.

When actuated, there is expansion across the pre-bend as well as along the axis of the pre-bend. The different effects of these two expansion directions, and the interaction with the pre-bend, enable different bending modes to be designed, in particular with different stiffness behavior and different speed of response.

Figure 5 shows a minor modification to the example of Figure 4, in which the edge 12 is straight where it connects to the support. The edge is thus constrained into a straight line where it connects to the support 14. Thus, the actuator no longer has a constant cross sectional shape from the edge to the remote tip, but instead the pre-bend is non-uniform and progresses between the edge (where it is forced to be straightened) to the remote tip where the pre-bend is in place.

Figure 6 shows an example in which the pre-bend is around the first axis 21. In this case, the edge 12 is straight.

Figure 7 shows an example in which the actuator unit has a pre-bend around both the first and the second axes 21, 22.

Typically, one pre-bend has a very different radius of curvature than the other. This arrangement may allow a snap-through behavior. The resistance to bending observes a step change when the curvature about one axis drops below a threshold (due to the isotropic expansion). The bending about the other axis then becomes much easier.

For a first set of examples, the rectangular shape may have any length to width ratio, for example between 0.1 and 100.
However, in a narrower set of examples, the rectangle has a length to width ratio less than 2. This has been found to be particularly suitable for creating a fast response speed, particularly when combined with pre-bends about both axes. The rectangle may even have a length to width ratio less than 1.

Thus, some ranges of length to width ratio which may be of interest are 2 < L/W < 1 for similar effects, and a broadest range of 100 < L/W < 0.1.

The actuator typically has dimensions of the order of mm or cm, for example a length in the range 1mm to 5cm such as 5mm to 2cm.

The bending radius for the pre-bend or pre-bends is for example 3mm to 100mm, more typically 5mm to 50mm and even more typically 7mm to 18mm. This is for example a natural curvature of a sheet after processing, e.g. applying gold electrodes with a rolling tool. Different diameters will be achieved by the use of differnet rolling tools.

A ratio between the radius for the two orthogonal pre-bends is 0 to 1 (where 0 means no curvature in the one of the directions so a ratio of x/∞ and where a ratio 1 corresponds to a spherical surface), or 0 to 0.5 (where 0.5 corresponds to a spheroid) or more preferably 0 to 0.1.

There may be a zero pre-bend about axis 22 (Figure 6) or about axis 21 (Figure 5). Thus, the ratios above may apply to both orientations.

Some examples will now be discussed in more detail.

In a first set of examples, the actuator unit comprises an ionic EAP polymer membrane with two electrodes. The actuator is pre-bent in any of the ways shown above. Different bending directions and curvatures may be obtained by cutting actuators from a curled sheet. The actuators have a main curvature in the curling direction of the sheet, and optionally also second (smaller, i.e. larger radius) curvature in the perpendicular direction. Another way to achieve a pre-bend is to repeatedly drive an initially flat actuator in one direction. Alternatively, a flat EAP layer may be attached to a passive layer which has the pre-bend and imposes this on the EAP layer.

Electrical actuation leads to isotropic (in-plane) expansion of the polymer (in the directions corresponding to the axes 21,22). This causes the actuator to bend in the orthogonal direction, i.e. the tip bends up or down as shown by the arrows in Figures 4 to 6.

In a second set of examples, the actuator unit comprises a field-driven EAP polymer layer with two electrodes, and a passive layer. The actuator has a pre-bend as explained above.

In one aspect, the invention addresses the problem that ionic polymers have an inherently slow response (>> 1 sec) due to the time needed for ion migration. An ionic actuator with a response time of 1s or faster can be realized by a combination of a design in accordance with the invention and a suitable drive scheme.

For this purpose, the actuator unit has a length to width aspect ratio smaller than 2, and there is a second (small) pre-bend about the length axis 22 of the actuator unit as well as a larger pre-bend about the width axis 21. For non-isotropically expanding materials with a substantial lateral component, the critical length/width ratio for allowing the snap-through will decrease.

The driving method is to drive the actuator around a "snap-through" working point. This is explained with reference to Figures 8 and 9.

Figure 8 shows the actuator drive voltage as plot 80 and shows the actuator tip displacement as plot 82 for one particular actuator design with unity aspect ratio (length 10mm and width 10mm). It shows that there are regions 84 where there is much more rapid actuation.

Figure 9 shows that different aspect ratios change this effect. Plots 90 and 92 are for different samples of the same actuator design with dominant curvature of the type shown in Figure 6 (i.e. about axis 21) and for length to width (L/W) aspect ratio of 2.

Plots 94 and 96 are again for actuators with dominant curvature of the type shown in Figure 6 and for L/W aspect ratio of 1 and 0.5 respectively. Plot 94 is the one used in Figure 8.

The snap through effect is most pronounced for aspect ratios of 1 and below. Plot 98 is for an actuator with dominant curvature of the type shown in Figure 4 (i.e. about axis 22).

A drive scheme to take advantage of this rapid response characteristic may be implemented in an open loop or closed loop system. In an open loop system, the driving scheme can have "overshoot" and/or "undershoot" features, and/or can be based on a look-up table to account for the driving history so that an applied actuation signal gives a predictable actuation response.

The snap-through effect relates to the moment of inertia (resistance to bending) which changes depending on the electrical actuation. The moment of inertia is determined by the curvature about the axis 22. At zero voltage, the moment of inertia is relatively high due to this curvature. When the actuation voltage increases such that the radius increases, tension is built-up in the actuator and the curvature about the axis 22 disappears. When the curvature is zero, the moment of inertia (bending resistance) becomes minimal. At this point the tension (elastic energy) is released and the actuator rapidly bends about the perpendicular axis 21 to a new position.

Note that the pre-bend about axis 21 is not essential and the actuator can be flat in that direction (Figure 4) or have a positive or negative value.

This snap-through function can be used to implement a threshold for the EAP actuator to enable use in a passive matrix.

The issues relating to providing a passive matrix driving scheme for EAP actuators are discussed in detail in WO 2016/193432.

A passive matrix array is a simple implementation of an array driving system using only row (n rows) and column (m columns) lines where between each cross point of a row line and a column line a device to be driven is connected for its driving. It has a lower cost and complexity than active matrix variants, as the latter require more wiring, more complex drivers and additional switching means in the cross points. As in the passive matrix a driver arrangement only requires (n+m) drivers to address up to (n x m) devices (actuators), this is a far more cost effective approach - and also saves cost and space of additional wiring.

An actuator as described above can be connected to the row line (first connection line) and column line (second connection line) in such a way that one electrode of the electrode arrangement is connected to the row line while the other electrode of the electrode arrangement is connected to the column line.

There are various possible passive matrix addressing schemes. In general however it is desired that an actuator device addressed in the passive matrix maintains its state without active driving circuitry until it can be refreshed again. To this end, the driving signal is divided into a row or select signal and a column or data signal. The select signal determines the row that is being addressed and all n devices on a row are selected simultaneously. When devices on a row are being selected, a select signal level is applied, and all other rows are unselected with an un-select signal level. The data signal is then applied with a data signal level for each of the m columns individually. An on-device thus is driven with an on data signal level and driving of an off-device corresponds to providing an off data signal level.

The drive signal provided to a device is then defined by the difference between the voltages applied over the crossing lines. The data signal determines whether an actuator device on the selected row is on or off, i.e. delivers output or not, and if it is on, how much actuation is provided.

An actuator that has a threshold voltage before it generates its output (e.g. actuation deformation) enables a passive matrix or a multiplexed device (i.e. a multiplexed segmented actuator array) to be formed without or with reduced crosstalk. Ideally it is possible to apply a non-zero voltage up to a threshold level before the actuator actuates and then gives an output. This threshold voltage may for example be of the order of, or higher than, the voltage required to change the shape of the actuator.

Figure 10 is used to explain a passive matrix scheme with one line at a time addressing. In this case, the actuation devices at a cross point have a threshold voltage Vth below which device output is substantially absent and above which device output is generated.

In this example, the threshold voltage (Vth) of a device exceeds the range of voltages of the data signal Vdr namely Vth>Vdr at any one desired driving signal. The voltage Vdr is the data voltage range required to fully actuate the actuator device.

In the example, the array is driven by row drivers capable of providing two-level addressing signals, i.e. a select voltage of -Vth and an unselect voltage of 0V. The column driver is capable of providing two-level or multi-level data signals, i.e. between 0V and Vdr.

Addressing the array proceeds in the manner explained in Figure 10 which shows an example of a 4x4 array.

All rows are initially addressed with 0V (unselected), that is, have 0V applied to the rows. In this situation, the maximum voltage difference across an individual device is Vdr (the maximum voltage from a column driver). As this is below Vth, all devices in the array will be in the non-actuated mode.

Then, as shown in Figure 10(a), the first row 1 is addressed (selected) with - Vth (or just below -Vth). Two columns 1 and 3 are driven with voltage Vdr, and two columns 2 and 4 with 0V. In this situation, the voltage difference across the two devices on column 1 and 3 is (Vdr + Vth) V (using the maximum voltage from a column driver, Vdr). As this is above Vth, these two devices in the row will be in the actuated mode as shown by solid circles. The voltage difference across the other two devices on column 2 and 4 is (0 + Vth) V (using the minimum voltage from a column driver, 0V), whereby these two devices in the row will be in the non-actuated mode. Also the voltage differences across the devices on rows other than 1 and on columns 1 and 3 have non-zero voltage differences of (Vdr + 0) V. This is however still below the Vth and hence also these devices are still in non-output mode.

The first row then reverts to addressing signal of 0V and all actuators in the row revert to the non-actuated mode.

The second row is then addressed (selected) with -Vth as shows in Figure 10(b). On off commences in the same way as for selection of the row 1.

The second row then reverts to addressing with 0V and all actuators in the second row revert to the non-actuated mode.

The third row is then addressed with -Vth as shown in Figure 10(c). Now three columns are driven with voltage Vdr, and one column with 0V. In this situation, the voltage difference across three of the devices is (Vdr + Vth) V (using the maximum voltage from a column driver, Vdr). As this is above Vth, these three devices in the row will be in the actuated mode. The voltage difference across the other device is (0 + Vth) V (using the minimum voltage from a column driver, 0V), whereby this device will be in the non-actuated mode.

The third row then reverts to 0V and all actuators in the row revert to the non-actuated mode

The fourth row is then addressed with -Vth as shown in Figure 10(d). Here all four columns are driven with voltage 0V. In this situation the voltage difference across all four devices is (0 + Vth) V (using the minimum voltage from a column driver, 0V), whereby all devices in the row will be in the non-actuated mode.

The forth row then reverts to 0V and all actuators in the row remain to the non-actuated mode.

The row addressing then follows a new cycle.

In this manner it is possible to individually actuate all devices in the array one line at a time, whereby the devices are actuated in a sequential manner. The column driver or data driver is used to actuate or not actuate a device on a row and to determine to what extent (grey scale type actuation) such device is actuated. This data signal can be a continuously variable or analogue data signal in the range between 0V and Vdr max. Alternatively that data signal can be a stepwise variable (digital) data signal in the range between 0V and Vdr max.

Further examples and details are provided in WO 2016/193432. The general principle is that when the driving voltage is below a certain threshold, the cross-section of the EAP actuator is curved, and the resistance to bending is high. In this case the actuator deformation will be negligible or minimal. When the driving voltage is above a certain threshold, the cross section becomes flat and the actuator will start to bend. This gives the required threshold behavior as explained above, in which the driver is able to selectively actuate or not actuate the devices around the snap-through position.

This type of driving scheme can also be used to actuate a plurality of actuators using the same multiplexed driving scheme even if the actuators are not arranged in the form of a matrix (e.g. a series of actuators aligned in a linear manner but connected using a multiplexing scheme).

The design may also provide variable stiffness operation so that the device is stiff when actuated in one direction and compliant when actuated in the other direction.

When a curvature as shown in Figure 4 is provided, with the dominant pre-bend about the length axis 22, the moment of inertia (resistance to bending in the orthogonal direction) is very high and the actuator behaves as relatively stiff.

When the actuator is driven such that the curvature is even further increased, e.g. at a positive voltage, the bending displacement in the out of plane direction is small and the actuator becomes even stiffer.

When the actuator is actuated in the other direction, e.g. at a negative voltage, such that the curvature flattens out or disappears, the moment of inertia becomes small, due to which the displacement is relatively large and the actuator behaves in a relatively compliant manner. This for example gives a stiffness of a factor 5 lower than compared to the non-actuated state.

Note that actuation with a positive voltage may correspond to actuation in one direction (e.g. bending up about the first axis 21) whereas actuation with a negative voltage may correspond to actuation in an opposite direction (e.g. bending down about he first axis 21).

The stiffness and displacement behavior can be tuned based on the length to width aspect ratio of the actuator. The displacement increases with an increase in the aspect ratio L/W whereas the stiffness decreases with an increase in the aspect ratio L/W.

Figure 11 shows a plot of displacement versus time for the same actuation timings as in Figure 8 (shown as dotted line 100).

Plot 102 is for a width 10mm and for an actuator which has a sufficient curvature that it cannot bend in the upward direction. It only curls even further in such a way that the actuator tip, where measurement spot is located, moves downward.

Plots 104 and 106 are different samples of an actuator design with a width 5mm and and which is able to curve upwardly.

The length is 10mm in each case. The increased length to width aspect ratio clearly gives increased displacement and the displacement also depends on the direction of the actuation.

The pre-bend may be uniform or it may vary over the surface. For example, a 3D shaped mesh may be provided on which the EAP polymer is sprayed, or 3D shaped processing tools may be used such as rolls. The moment of inertia may thus vary over the surface in segments or gradually. As a result, the actuation speed and stiffness may be varied over the surface which can be useful in various applications as mentioned below.

In all examples, the electroactive material actuator is typically based on an electroactive polymer material, although the invention can in fact be used for devices based on other kinds of EAM material. Such other EAM materials are known in the art and the person skilled in the art will know where to find them and how to apply them. A number of options will be described herein below.

A common sub-division of EAM devices is into field-driven and current or charge (ion) driven EAMs. Field-driven EAMs are actuated by an electric field through direct electromechanical coupling, while the actuation mechanism for current or charge driven EAMs involves the diffusion of ions. The latter mechanism is more often found in the corresponding organic EAMs such as EAPs. While field driven EAMs generally are driven with voltage signals and require corresponding voltage drivers/controllers, current driven EAMs generally are driven with current or charge signals sometimes requiring current drivers. Both classes of materials have multiple family members, each having their own advantages and disadvantages.

Field driven EAMs can be organic or inorganic materials and if organic can be single molecule, oligomeric or polymeric. For the current invention they are preferably organic and then also oligomeric or even polymeric. The organic materials and especially polymers are an emerging class of materials of growing interest as they combine the actuation properties with material properties such as light weight, cheap manufacture and easy processing.

The field driven EAMs and thus also EAPs are generally piezoelectric and possibly ferroelectric and thus comprise a spontaneous permanent polarization (dipole moment). Alternatively, they are electrostrictive and thus comprise only a polarization (dipole moment) when driven, but not when not driven. Alternatively they are dielectric relaxor materials. Such polymers include, but are not limited to, the sub-classes: piezoelectric polymers, ferroelectric polymers, electrostrictive polymers, relaxor ferroelectric polymers (such as PVDF based relaxor polymers or polyurethanes), dielectric elastomers, liquid crystal elastomers. Other examples include electrostrictive graft polymers, electrostrictive paper, electrets, electroviscoelastic elastomers and liquid crystal elastomers.

The lack of a spontaneous polarization means that electrostrictive polymers display little or no hysteretic loss even at very high frequencies of operation. The advantages are however gained at the expense of temperature stability. Relaxors operate best in situations where the temperature can be stabilized to within approximately 10 °C. This may seem extremely limiting at first glance, but given that electrostrictors excel at high frequencies and very low driving fields, then the applications tend to be in specialized micro actuators. Temperature stabilization of such small devices is relatively simple and often presents only a minor problem in the overall design and development process.

Relaxor ferroelectric materials can have an electrostrictive constant that is high enough for good practical use, i.e. advantageous for simultaneous sensing and actuation functions. Relaxor ferroelectric materials are non-ferroelectric when zero driving field (i.e. voltage) is applied to them, but become ferroelectric during driving. Hence there is no electromechanical coupling present in the material at non-driving. The electromechanical coupling becomes non-zero when a drive signal is applied and can be measured through applying the small amplitude high frequency signal on top of the drive signal. Relaxor ferroelectric materials, moreover, benefit from a unique combination of high electromechanical coupling at non-zero drive signal and good actuation characteristics.

The most commonly used examples of inorganic relaxor ferroelectric materials are: lead magnesium niobate (PMN), lead magnesium niobate-lead titanate (PMN-PT) and lead lanthanum zirconate titanate (PLZT). But others are known in the art.

PVDF based relaxor ferroelectric based polymers show spontaneous electric polarization and they can be pre-strained for improved performance in the strained direction. They can be any one chosen from the group of materials herein below.

Polyvinylidene fluoride (PVDF), Polyvinylidene fluoride - trifluoroethylene (PVDF-TrFE), Polyvinylidene fluoride - trifluoroethylene - chlorofluoroethylene (PVDF-TrFE-CFE), Polyvinylidene fluoride - trifluoroethylene - chlorotrifluoroethylene) (PVDF-TrFE-CTFE), Polyvinylidene fluoride- hexafluoropropylene (PVDF - HFP), polyurethanes or blends thereof.

The sub-class dielectric elastomers includes, but is not limited to: acrylates, polyurethanes, silicones.

Examples of ionic-driven EAPs are conjugated polymers, carbon nanotube (CNT) polymer composites and Ionic Polymer Metal Composites (IPMC).

The sub-class conjugated polymers includes, but is not limited to:
polypyrrole, poly-3,4-ethylenedioxythiophene, poly(p-phenylene sulfide), polyanilines.

The materials above can be implanted as pure materials or as materials suspended in matrix materials. Matrix materials can comprise polymers.

To any actuation structure comprising EAM material, additional passive layers may be provided for influencing the behavior of the EAM layer in response to an applied drive signal.

The actuation arrangement or structure of an EAM device can have one or more electrodes for providing the control signal or drive signal to at least a part of the electroactive material. Preferably the arrangement comprises two electrodes. The EAM layer may be sandwiched between two or more electrodes. This sandwiching is needed for an actuator arrangement that comprises an elastomeric dielectric material, as its actuation is among others due to compressive force exerted by the electrodes attracting each other due to a drive signal. The two or more electrodes can also be embedded in the elastomeric dielectric material. Electrodes can be patterned or not.

It is also possible to provide an electrode layer on one side only for example using interdigitated comb electrodes.

A substrate can be part of the actuation arrangement. It can be attached to the ensemble of EAP and electrodes between the electrodes or to one of the electrodes on the outside.

The electrodes may be stretchable so that they follow the deformation of the EAM material layer. This is especially advantageous for EAP materials. Materials suitable for the electrodes are also known, and may for example be selected from the group consisting of thin metal films, such as gold, copper, or aluminum or organic conductors such as carbon black, carbon nanotubes, graphene, poly-aniline (PANI), poly(3,4-ethylenedioxythiophene) (PEDOT), e.g. poly(3,4-ethylenedioxythiophene) poly(styrenesulfonate) (PEDOT:PSS). Metalized polyester films may also be used, such as metalized polyethylene terephthalate (PET), for example using an aluminum coating.

The materials for the different layers will be selected for example taking account of the elastic moduli (Young's moduli) of the different layers.

Additional layers to those discussed above may be used to adapt the electrical or mechanical behavior of the device, such as additional polymer layers.

An electroactive polymer structure as described above may be used for actuation and/or for sensing. The most prominent sensing mechanisms are based on force measurements and strain detection. Dielectric elastomers, for example, can be easily stretched by an external force. By putting a low voltage on the sensor, the strain can be measured as a function of voltage (the voltage is a function of the area).

Another way of sensing with field driven systems is measuring the capacitance-change directly or measuring changes in electrode resistance as a function of strain.

Piezoelectric and electrostrictive polymer sensors can generate an electric charge in response to applied mechanical stress (given that the amount of crystallinity is high enough to generate a detectable charge). Conjugated polymers can make use of the piezo-ionic effect (mechanical stress leads to exertion of ions). CNTs experience a change of charge on the CNT surface when exposed to stress, which can be measured. It has also been shown that the resistance of CNTs change when in contact with gaseous molecules (e.g. O₂, NO₂), making CNTs usable as gas detectors.

There are many uses for electroactive material actuators and sensors. In many applications the main function of the product relies on the (local) manipulation of human tissue, or the actuation of tissue contacting interfaces. In such applications EAP actuators provide unique benefits mainly because of the small form factor, the flexibility and the high energy density. Hence EAPs can be easily integrated in soft, 3D shaped and / or miniature products and interfaces. Examples of such applications are:
Skin cosmetic treatments such as skin actuation devices in the form of EAP based skin patches which apply a constant or cyclic stretch to the skin in order to tension the skin or to reduce wrinkles;
Respiratory devices with a patient interface mask which has an EAP based active cushion or seal, to provide an alternating normal pressure to the skin which reduces or prevents facial red marks;
Electric shavers with an adaptive shaving head. The height of the skin contacting surfaces can be adjusted using EAP actuators in order to influence the balance between closeness and irritation;
Oral cleaning devices such as an air floss with a dynamic nozzle actuator to improve the reach of the spray, especially in the spaces between the teeth. Alternatively, toothbrushes may be provided with activated tufts;
Consumer electronics devices or touch panels which provide local haptic feedback via an array of EAP transducers which is integrated in or near the user interface;
Catheters with a steerable tip to enable easy navigation in tortuous blood vessels. The actuator function for example controls the bending radius to implement steering, as explained above.

Another category of relevant application which benefits from EAP actuators relates to the modification of light. Optical elements such as lenses, reflective surfaces, gratings etc. can be made adaptive by shape or position adaptation using EAP actuators. Here the benefits of EAP actuators are for example the lower power consumption.

Some examples where asymmetric stiffness control is of interest are outlined below.

Actuators may be used in valves, including human impantables such as prosthetic heart valves or valves in organ-on-chip applications or microfluidic devices. For many valves, an asymmetric behavior is desired: compliant and large displacement in a direction with the flow, and stiff in a direction against the flow. Sometimes high actuation speed is required to close a valve quickly.

A flexible display actuator is desired in some applications, for example in smart bracelets. When the flexible display moves to another position or shape for better reading or visual performance, a large displacement is required. When the display is in its rest position, the display actuator must be stiff to hold its position firmly.

There are also application is noise and vibration control systems. Using stiffness variation, it is possible to move away from resonance frequencies and hence reduce vibrations. This is useful for example in in surgery robotic tools where precision is important.

Soft robotics (artificial muscle systems supporting the human body) for example is used to support or hold a body part in a certain position (e.g. against gravity), during which stiffness is required. When the body part moves in the opposite direction resistance is not required and low stiffness is desirable.

A segmented catheter application may also benefit from variable stiffness. For example, when the catheter tip bends around a corner, it is desired that the segment just behind the tip is temporarily compliant such that the rest of the catheter follows the tip.

The threshold-based passive matrix driving system explained above may for example be of interest for arrays with actuated ultrasound transducers.

As explained above, the preferred material for the electroactive material actuator is an electroactive polymer (ionic or field driven), but also other materials with isotropic expansion can be considered such as a thermally activated hydrogel, light activated liquid crystal polymer networks, or bi-metal actuators.

The invention may make use of a perfectly isotropically expanding actuator unit. However, near isotropic expansion (so that there is at least a substantial lateral component of actuation) would behave in a similar manner, though less pronounced if the lateral expansion coefficient is significantly smaller than the longitudinal expansion coefficient.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage. Any reference signs in the claims should not be construed as limiting the scope.

## Claims

1. A device comprising:
- an electroactive material actuator unit comprising a plate shaped structure (10) and a first edge (12);
- a support (14) to which the first edge (12) of the electroactive material unit is clamped, the ends of the first edge defining end points of an imaginary straight edge line (18); and
wherein the actuator unit:
- has a pre-bend about a first axis (21) which is parallel to said imaginary edge line and/or about a second axis (22) which is perpendicular to said imaginary edge line, and
- is adapted to expand with expansion coefficients along the first and/or second axes which differ by less than 20%.

2. A device as claimed in claim 1, wherein the actuator is adapted to expand isotropically in-plane when actuated.

3. A device as claimed in claim 1, wherein the first edge (12) is straight where it connects to the support.

4. A device as claimed in any preceding claim, wherein the actuator unit comprises a circumferential shape in the form of a rectangle.

5. A device as claimed in any claim 4, wherein the rectangle has a length to width ratio of 2 or less.

6. A device as claimed in any claim 5, wherein the rectangle has a length to width ratio less of 1 or less1.

7. A device as claimed in any preceding claim, wherein the, or each pre-bend has a radius in the range 5mm to 50mm.

8. A device as claimed in any preceding claim wherein the actuator unit has a pre-bend about the first axis (21) and about the second axis (22).

9. A device as claimed in any claim 8, wherein a ratio of the radius of smaller radius pre-bend to the radius of the larger radius pre-bend is in the range 0 to 0.5, such as 0 to 0.1.

10. A device as claimed in any preceding claim, wherein the electroactive material actuator unit has a different stiffness when actuated in one direction compared to when actuated in an opposite direction.

11. A device as claimed in any preceding claim, wherein the pre-bend about the first axis and/or about the second axis has a radius of curvature which varies with position.

12. A device as claimed in any preceding claim, wherein the electroactive material actuator unit is a current-driven actuator.

13. A device as claimed in claim 12, wherein the electroactive material actuator unit is an ionic polymer metal composite actuator.

14. A device as claimed in any one of claims 1 to 12, wherein the electroactive material actuator unit is a field-driven actuator.

15. A device as claimed in any of the previous claims comprising a driver (20) for applying an actuation signal to the electroactive material actuator unit,
